# EUROPÄISCHE PATENTSCHRIFT

(11) **EP 0 647 312 B1**
(45) Veröffentlichungstag und Bekanntmachung des Hinweises auf die Patenterteilung: **11.09.1996**
(21) Anmeldenummer: 93912944.1
(22) Anmeldetag: 09.06.1993
(51) Int. Cl.: G01D 21/00, H02K 15/00, G01R 31/34

(54) **INSPEKTION EINER DYNAMOELEKTRISCHEN MASCHINE IN EINEM SPALT ZWISCHEN EINEM STATOR UND EINEM ROTOR**
INSPECTION OF A DYNAMO-ELECTRIC MACHINE IN A GAP BETWEEN A STATOR AND A ROTOR
CONTROLE D'UNE MACHINE DYNAMO-ELECTRIQUE DANS UN INTERVALLE COMPRIS ENTRE LE STATOR ET LE ROTOR

(30) Priorität: 22.06.1992 EP 92110503
(43) Veröffentlichungstag der Anmeldung: 12.04.1995
(73) Patentinhaber: SIEMENS AKTIENGESELLSCHAFT, 80333 München (DE)
(72) Erfinder: LONGREE, Alexander, D-4330 Mülheim a. d. Ruhr (DE)
(86) Internationale Anmeldenummer: EP9301474
(87) Internationale Veröffentlichungsnummer: WO9400738

(56) Entgegenhaltungen:
- NL-A- 9 101 779
- US-A- 4 255 762
- US-A- 4 889 000

## Beschreibung

Die Erfindung betrifft eine Inspektion einer dynamoelektrischen Maschine, welche einen Stator und einen Rotor aufweist, wobei der Rotor bezüglich einer Hauptachse etwa kreiszylindrisch, um die Hauptache drehbar und unter Belassung eines Spaltes (der üblicherweise ungeachtet der in der Ma-schine vorliegenden Gasatmosphäre und des installierten Kühlsystems als "Luftspalt" bezeichnet wird) in einer bezüglich der Hauptachse etwa kreiszylindrischen Ausnehmung des Stators angeordnet ist, wobei zur Durchführung der Inspektion entsprechende Mittel, also optische, akustische und/oder mechanische Instrumente sowie Lampen, Greifer u. dgl., in den Spalt zwischen dem Stator und dem Rotor eingeführt werden.

Die Gewährleistung des störungsfreien Betriebes einer dynamoelektrischen Maschine, insbesondere einer dynamoeiektrischen Großmaschine, beispielsweise eines Turbogenerators, sowie die rechtzeitige Feststellung einer sich anbahnenden Fehlfunktion einer solchen Maschine erfordern regelmäßige, in Intervallen von einigen Monaten bis zu einigen Jahren wiederholte Inspektionen, wobei stets vielfältige Untersuchungen und Prüfungen vorzunehmen sind. Eine in diesem Zusammenhang mögliche Prüfung ist die visuelle Inspektion der entsprechend zugänglichen Oberflächen der Komponenten der Maschine, insbesondere der Oberflächen des Stators und des Rotors. Weitere mögliche Prüfungen umfassen die Untersuchung der Komponenten mittels Ultraschall nach verschiedenen Verfahren, sowie Prüfungen der Magnetisierbarkeit von in jeder dynamoelektrischen Maschine vorhandenen ferromagnetischen Komponenten, beispielsweise von Jochen aus aufeinandergeschichteten Blechen in den Statoren. Für solche Prüfungen kann beispielsweise die Einwirkung schwacher und lokal begrenzter Magnetfelder auf das Joch bestimmt und ausgewertet werden. Hinzuweisen ist auch auf mechanische Prüfungen, insbesondere auf Festigkeits- und Rißprüfungen. Nicht zuletzt sind Möglichkeiten erwünscht, kleinere Teile, z. B. gelöste Schrauben u. dgl., aus der Maschine bergen zu können.

Die üblichen Methoden zur Inspektion dynamoelektrischer Maschinen erfordern jeweils die Entfernung des Rotors, was insbesondere bei dynamoelektrischen Großmaschinen, deren elektrische Leistungsabgaben bzw. Leistungsaufnahmen typisch bei mehr als 50 MVA liegen, höchst zeitraubend und kostenaufwendig ist. Um solche aufwendigen Demontagearbeiten entbehrlich zu machen, ist eine Einrichtung bekannt, die es gestattet, in einer dynamoelektrischen Großmaschine durch den Spalt zwischen Stator und Rotor eine Instrumentenplattform zu ziehen, welche an Führungsschienen oder Führungsseilen, die von einem Ende der Großmaschine zum anderen durch den Spalt hindurchgeführt sind, entlangläuft. Aufgrund der üblichen Dimensionen dynamoelektrischer Großmaschinen ist die Instrumentenplattform allerdings weder frei von Vibrationen zu halten noch mit besonderer Genauigkeit zu positionieren. Außerdem kann sich die Instrumentenplattform in dem Spalt verkanten und einklemmen, wonach sie nicht ohne ein erhebliches Risiko für die inspizierte Maschine und kaum ohne die extrem aufwendige Entnahme des Rotors aus dem Stator zu bergen wäre. Die Verwendung dieser Einrichtung ist daher durchaus problematisch.

Aus dem US-Patent 4,255,762 ist eine Einrichtung zur Inspektion von Rohren bekannt, bei der eine Sonde mit einem optischen Inspektionssystem an einem Tragarm in das zu inspizierende Rohr eingeführt wird. Eine solche Einrichtung ist in dynamoelektrischen Maschinen nur unter Inkaufnahme von Nachteilen verwendbar, da aufgrund der üblichen Abmessungen der zu inspizierenden Spalte die erforderlichen Tragarme kaum vibrationsfrei und unter Vermeidung von Kollisionen mit den Statoren oder Rotoren einsetzbar sind.

Die Inspektion einer dynamoelektrischen Maschine in einem Spalt zwischen einem Stator und einem Rotor nebst einer dementsprechenden Vorrichtung geht hervor aus dem US-Patent 4,889,000. Dabei wird an dem Rotor eine in den Spalt hineinreichende Verschiebeeinrichtung nach Art einer Schiene montiert, welche sich an Ketten um den Rotor herum bewegen kann. Auf dieser Schiene sitzt ein Instrumententräger, welcher durch den Spalt fahren kann und verschiedene Mittel zur Durchführung von Inspektionen trägt. Problematisch bei dieser Einrichtung ist, daß spezielle Nuten an dem Joch zur Halterung und Führung des Instrumententrägers notwendig sind, sowie die Fixierung der Schiene an dem Rotor.

Mit der Erfindung soll eine Inspektion einer dynamoelektrischen Maschine in einem Spalt zwischen Stator und Rotor ermöglicht werden, wobei Mittel zur Durchführung der Inspektion sicher und vibrationsfrei, auch und insbesondere über Distanzen der Größenordnung mehrerer Meter, in den Spalt einführbar, dort bewegbar und präzise positionierbar sind, wobei keine komplizierten Führungseinrichtungen benötigt werden und wobei jedwedes Risiko, daß bei einer während der Inspektion eintretenden Fehlfunktion zur Bergung der verwendeten Einrichtungen die zu inspizierende Maschine zerlegt werden muß, ausgeschlossen sein soll.

Zur Lösung dieser Aufgabe wird ein Instrumententräger zur Inspektion einer dynamoelektrischen Maschine, die einen Stator und einen Rotor aufweist, wobei der Rotor bezüglich einer Hauptachse etwa kreiszylindrisch, um die Hauptachse drehbar und unter Belassung eines Spaltes in einer bezüglich der Hauptachse etwa kreiszylindrischen Ausnehmung des Stators angeordnet ist, angegeben, welcher Instrumententrager Mittel zur Durchführung der Inspektion trägt sowie eine Vielzahl von Rollen aufweist, die, in einer Ebene senkrecht zu einer Achse des Instrumententragers, welche bei der Inspektion mit der Hauptachse zur Deckung gebracht wird, gesehen, gegeneinander versetzt sind und deren jede um eine im wesentlichen senkrecht zu der Achse ausgerichtete zugehörige Drehachse drehbar ist, und welcher erfindungsgemäß ein die Achse ringförmig umfangendes Rahmenteil aufweist, an dem die Mittel zur Durchführung der Inspektion sowie die Rollen befestigt sind.

Erfindungsgemäß findet der Instrumententräger Verwendung zur Inspektion der dynamoelektrischen Maschine, wobei der Instrumententräger in den Spalt zwischen dem Stator und dem Rotor eingeführt wird, so daß das Rahmenteil den Rotor umfängt und die Rollen über die Ausnehmung des Stators rollen.

Die Mittel zur Inspektion der dynamoelektrischen Maschine sind auswählbar aus einer großen Vielfalt von optischen, akustischen und mechanischen Instrumenten zur Durchführung der Inspektion sowie einer großen Vielfalt von Hilfseinrichtungen, wie z. B. Lampen, Greifern und anderen hydraulischen oder pneumatischen Einrichtungen und Manipulatoren. Beispiele für solche Mittel sind dem US-Patent 4,889,000 entnehmbar.

Der Instrumententräger ist eine mechanisch stabile Einheit, die den Luftspalt zwischen Stator und Rotor einer dynamoelektrischen Maschine befahren und dabei Mittel zur Durchführung der Inspektion tragen kann. Er ist unabhängig von Führungseinrichtungen, die außerhalb der Maschine anzuordnen sind und die den Instrumententräger an Tragarmen, Schienen o. dgl. festhalten. Auf diese Weise wird eine Beeinträchtigung des Instrumententrägers und der daran befestigten Mittel durch Vibrationen und ähnliche Beeinflussungen vermieden. Der Instrumententräger ist stets zuverlässig und vibrationsfrei positionierbar und gestattet somit an jeder Stelle des Spaltes eine exakte und reproduzierbare Prüfung des Stators und/oder des Rotors. Darüber hinaus besteht keine Gefahr, daß der Instrumententräger sich in dem Spalt verkantet und verklemmt und nur mit erheblichem Aufwand und unter Inkaufnahme großer Risiken aus dem Spalt zu bergen wäre.

Es versteht sich, daß die Abmessungen des Instrumententrägers an die Abmessungen des zu befahrenden Spaltes anzupassen sind. Da in der Regel Luftspalte in dynamoelektrischen Großmaschinen zumindest etwa 3 cm hoch sind, stellt dies jedoch kein wesentliches Problem dar. Darüber hinaus ist festzuhalten, daß für Inspektionen Instrumente jedweder denkbaren Art in hinreichender Miniaturisierung verfügbar sind, so daß die Erfindung keinerlei Beschränkungen hinsichtlich der wünschbaren Inspektionsmethoden unterliegt; auch hierzu wird auf das US-Patent 4,899,000 hingewiesen.

Der Instrumententräger ist mit einer großen Vielfalt von Instrumenten ausrüstbar: Möglich sind optische Inspektionseinrichtungen wie z. B. Videaokameras, ggf. ergänzt durch entsprechende Beleuchtungseinrichtungen; auch kommen Ultraschallprüfeinrichtungen vielerlei Art, Einrichtungen für magnetische Inspektionen sowie mechanische Prüfeinrichtungen zur Durchführung von Festigkeitsprüfungen u. dgl. in Frage. Weiterhin ist es denkbar, mechanische Manipulatoren, beispielsweise Greifer, zur Bergung loser Teile und/oder zur Durchführung kleinerer Reparaturen sowie Wartungs- und/oder Reinigungsarbeiten vorzusehen. Zur Steuerung und zum Betrieb der der Inspektion dienenden Mittel sowie ggf. auch zur Energieversorgung von Antriebseinrichtungen an dem und/oder für den Instrumententräger sind lediglich flexible Leitungen, insbesondere elektrische Leitungen, erforderlich, von denen keine Beeinträchtigung ausgeht und die problemlos zusammen mit dem Instrumententräger durch den Luftspalt führbar sind. Diese Leitungen können an eine außerhalb der zu inspizierenden Maschine postierbare Steuer- und Auswerteeinrichtung, beispielsweise einen Kleincomputer mit entsprechenden Schnittstellen, angeschlossen werden. Außerdem ist es denkbar, den Instrumententräger mit pneumatischen und/oder hydraulischen Einrichtungen, insbesondere Motoren und/oder Greifern, zu versehen. Flexible Druckleitungen für Gase und/oder Flüssigkeiten können ebenso wie elektrische Leitungen problemlos verwendet werden. In keinem Fall erfordert der Instrumententräger schwierig zu handhabende Verbindungselemente wie z. B. Schienen.

Im Rahmen einer bevorzugten Ausbildung weist das Rahmenteil des Instrumententrägers in einer bezüglich der Hauptachse radialen Orientierung eine Elastizität auf, so daß der um die Hauptachse zu bestimmende Umfang des Rahmenteils durch elastische Verformung variabel ist. Die durch elastische Verformung mögliche Umfangsänderung liegt dabei bei einem Instrumententräger zur Verwendung in dynamoelektrischen Großmaschinen nach Art von Turbogeneratoren in der Größenordnung von einem Zentimeter, insbesondere bei höchstens etwa fünf Zentimetern. Die Elastizität des Rahmenteils erlaubt es, daß es sich dem Spalt, in den es bestimmungsgemäß eingeführt wird, anpassen kann, wobei ggf. kleine Unregelmäßigkeiten ausgeglichen werden können. Dies ist deshalb wichtig, weil die Statoren vieler dynamoelektrischer Maschinen, insb. die Statoren von Turbogeneratoren, nicht monolithische feste Körper sind, sondern Strukturen, beispielsweise viele entlang der Hauptachse hintereinander angeordnete und voneinander beabstandete Blechpakete, haben. Darüber hinaus muß auch die Oberfläche der Ausnehmung des Stators keineswegs glatt sein, sondern kann einen mehr oder weniger rauhen Belag aus Kunstharz o. dgl. haben - letzteres ist insbesondere dann kaum vermeidbar, wenn der Stator im letzten Schritt seiner Herstellung eine Kunstharztränkung erhält. Ein Instrumententräger mit einem in der beschriebenen Weise elastischen Rahmenteil kann darüber hinaus möglicherweise auch in mehreren voneinander verschiedenen Statoren eingesetzt werden, deren Ausnehmungen mehr oder weniger voneinander abweichende Maße haben.

Die Elastizität des Rahmenteils des Instrumententrägers wird vorteilhafterweise gewährleistet durch zumindest ein in dem Rahmenteil installiertes Federelement, welches in bezüglich der Hauptachse tangentialer Richtung elastisch ist. Besonders vorteilhaft ist es, wenn das Rahmenteil zwei oder drei Federelemente aufweist, welche weitgehend gleichmäßig um die Hauptachse verteilt sind.

Um die Anpassung des Instrumententrägers an die Abmessungen des zu befahrenden Spaltes weiter zu verbessern, weist das Rahmenteil zumindest eine Dehnvorrichtung auf, durch welche es radial dehnbar ist und welche über zugehörige Anschlußleitungen extern bedienbar ist. Auf diese Weise kann der Instrumententräger vor der Einführung in den Spalt auf einen Umfang gebracht werden, bei dem er nicht überall fest an der Ausnehmung des Stators anliegt, und nach vollendeter Einführung durch Betätigen der Dehnvorrichtung mit sämtlichen Rollen in guten und belastbaren Kontakt mit dem Stator gebracht werden. Insbesondere erlaubt die Dehnvorrichtung eine Einstellung des Drucks, den die Rollen auf die Ausnehmung ausüben, so daß auch die Betriebssicherheit des Instrumententrägers verbessert werden kann. Die Dehnvorrichtung enthält als ein wesentliches Bestandteil vorteilhafterweise eine in bezüglich der Hauptachse etwa tangentialer Richtung wirkende pneumatische Verschiebeeinrichtung, da eine solche Verschiebeeinrichtung durch die Elastizität des Gases, mit dem sie beaufschlagt wird, auch nach vollendeter Anpressung der Rollen des Instrumententrägers an den Stator eine Elastizität des Rahmenteils gewährleistet.

Günstigerweise sind die Rollen des Instrumententrägers installiert in Rollengestellen, die in einer Vielzahl vorhanden und durch eine Vielzahl von gebogenen Stäben untereinander verbunden sind. Dabei trägt jedes Rollengestell mehrere, bezüglich der Hauptachse hintereinander angeordnete Rollen. Vorteilhafterweise weist der Instrumententräger zwischen vier und acht, vorzugsweise sechs, Rollengestelle auf. Die Verbindung zweier Rollengestelle miteinander erfolgt günstigerweise jeweils mit zwei zueinander etwa parallelen Stäben. Günstigerweise besteht jeder Stab aus einem elastisch biegsamen Werkstoff, wofür Stahl, Leichtmetall und Verbundwerkstoffe wie glasfaserverstärkte Kunststoffe in Frage kommen.

Jedwede Ausbildung des Instrumententrägers mit Rollengestellen und Stäben ist durch den Austausch von Stäben an Spalte verschiedener Abmessungen anpaßbar. Es kann ausreichen, zur Inspektion einer Vielzahl von dynamoelektrischen Maschinen zu einem Satz von Rollengestellen und Mitteln zur Durchführung der Inspektionen eine hinreichende Anzahl von Sätzen von Stäben bereitzustellen. Die Stäbe können über einfach fixierbare und lösbare Schraub- oder Schnappverbindungen mit den Rollengestellen verbunden werden.

Vorteilhafterweise ist im Rahmen jedweder Ausbildung jede Rolle des Instrumententrägers nach Art eines Fasses bauchig ausgewölbt. Eine solche Gestaltung vermeidet, daß Kanten an den Rollen mit der Ausnehmung des Stators in Berührung kommen und diese womöglich beschädigen. Auch eignen sich bauchig ausgewölbte Rollen, insbesondere in Verbindung mit einem elastisch verformbaren Rahmenteil, zum Ausgleich kleinerer Unebenheiten der Oberfläche des Stators, über die die Rollen bewegt werden.

Besonders vorteilhaft ist es auch, in dem Instrumententräger die Rollen zu installieren als bezüglich der Hauptachse hintereinander angeordnete, einander dicht benachbarte gepaarte Rollen, welche auch als "Doppelrollen" bezeichenbar sind. Diese Ausgestaltung erlaubt ebenfalls einen Ausgleich von Unebenheiten in der Oberfläche des Stators, was insbesondere wichtig ist bei Statoren dynamoelektrischer Großmaschinen, die aus vielzähligen hintereinander angeordneten, voneinander beabstandeten Blechpaketen bestehen (vgl. oben). Sofern die vorzugsweise auf einige Zentimeter zu bemessende Beabstandung zueinander gepaarter Rollen geeignet gewählt ist, kann sichergestellt werden, daß stets eine Rolle jedes Paares auf einem Blechpaket rollt. Gegebenenfalls kann dies noch verbessert werden dadurch, daß die Beabstandung etwa hintereinander angeordneter Paare von Rollen und/oder die Beabstandung der Rollen in jedem Paar geeignet gewählt wird.

Eine besonders günstige Weiterbildung des Instrumententrägers ist gekennzeichnet durch zumindest einen ersten Motor, der über entsprechende Kraftübertragungseinrichtungen zumindest eine Rolle antreiben kann und über zugehörige Anschlußleitungen extern bedienbar ist. Im Rahmen dieser Weiterbiidung ist der Instrumententräger eine selbstfahrende Einrichtung zur Befahrung des Spaltes der zu inspizierenden dynamoelektrischen Maschine und eignet sich insbesondere für eine weitgehend vollständig automatisierte Inspektion bzw. eine Inspektion, die weitgehend vollständig von einer abseits der zu inspizierenden Maschine aufgestellten Steuereinrichtung aus durchführbar ist.

Vorteilhafterweise ist der erste Motor in ein mehrere Rollen aufweisendes Rollengestell eingebaut, und alle Rollen des Rollengestells sind durch den ersten Motor antreibbar.

Besonders vorteilhaft unbeschadet anderweitiger Ausgestaltungen ist es, wenn der Instrumententräger eine Instrumentenplattform aufweist, die an dem Rahmenteil gehaltert und entlang des Rahmenteils um die Hauptachse bewegbar ist, und welche die Mittel zur Durchführung der Inspektion trägt. Die Halterung einer solchen Instrumentenplattform erfolgt vorteilhafterweise an einer Führungsschiene, entlang derer die Instrumentenplattform bewegbar ist. Besonders vorteilhaft ist es auch, wenn die Instrumentenplattform einen zweiten Motor aufweist, der mit dem Rahmenteil, insbesondere mit einer eventuell vorhandenen Führungsschiene, in Kraftschluß steht, durch den die Instrumentenplattform bewegbar ist und der über zugehörige Anschlußleitungen extern bedienbar ist.

Die Instrumentenplattform, vorteilhafterweise geführt an einer Führungsschiene und/oder bewegbar durch einen besonders dafür vorgesehenen zweiten Motor, ermöglicht eine Bewegung der Mittel zur Durchführung der Inspektion nicht nur in Richtungen parallel zur Hauptachse, sondern auch in Richtungen tangential um die Hauptachse herum. Mittels einer solchen Instrumentenplattform können die Mittel zur Durchführung der Inspektion nach Belieben zu jeder gewünschten Position in dem Spalt verfahren werden, womit eine vollständig extern gesteuerte, möglicherweise weitgehend vollständig automatisierte Inspektion möglich ist. Insbesondere gestattet eine solche Instrumentenplattform Positionskorrekturen der Mittel zur Durchführung der Inspektion in tangentialer Richtung und kann so Positionsungenauigkeiten korrigieren, die beim Einbringen des Instrumententrägers in den Spalt aufgetreten sein können. Auch gestattet das Vorsehen der Instrumentenplattform womöglich die Durchführung der Inspektion weitgehend vollständig von einer externen Steuer- und Auswerteeinrichtung aus.

Der Instrumententräger jedweder Ausgestaltung hat günstigerweise eine bezüglich der Hauptachse in einer radialen Richtung zu bestimmende maximale Dicke, welche kleiner als zehn Zentimeter, insbesondere kleiner als fünf Zentimeter ist. Derart ist der Instrumententräger für eine große Vielfalt von dynamoelektrischen Maschinen geeignet, da jedenfalls in dynamoelektrischen Maschinen nach Art der Turbogeneratoren die Luftspalte stets einige Zentimeter bis etwa zehn Zentimeter hoch sind und somit ein Einführen des Instrumententrägers zur Inspektion erlauben.

Ausführungsbeispiele der Erfindung werden anhand der Zeichnung erläutert. Zur Verdeutlichung spezifischer Merkmale ist die Zeichnung teilweise schematisiert und/oder leicht verzerrt ausgeführt. Im einzelnen zeigen:
Fig. 1 eine dynamoelektrische Maschine mit einem Instrumententräger gemäß der Erfindung;
Fig. 2 eine Teilansicht einer Ausführungsform des Instrumententrägers;
Fig. 3 eine Teilansicht eines Instrumententrägers im Stator einer dynamoelektrischen Maschine;
Fig. 4 einen Ausschnitt aus einer weiteren Ausführungsform des Instrumententrägers;
Fig. 5 eine Instrumentenplattform zur Verwendung im Instrumententräger;
Fig. 6 eine Teilansicht einer weiteren Ausführungsform des Instrumententrägers.

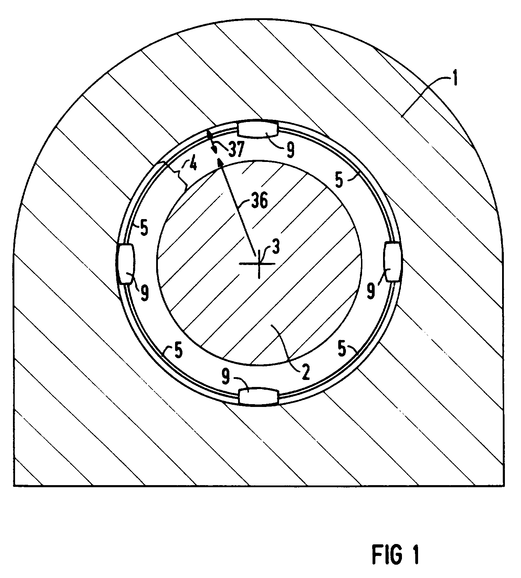

Fig. 1 zeigt, schematisiert, einen Querschnitt durch eine dynamoelektrische Maschine senkrecht zu der Hauptachse. Die Maschine weist einen Stator 1 und einen in einer Ausnehmung des Stators 1 angeordneten Rotor 2 auf, der um die mit einem Kreuz angedeutete Hauptachse 3 drehbar ist. Zwischen dem Stator 1 und dem Rotor 2 befindet sich ein Spalt 4. In diesem Spalt 4 befindet sich der Instrumententräger, von dem das Rahmenteil 5 sowie Rollen 9, welche auf der Oberfläche des Stators 1 in dem Spalt 4 abrollen, sichtbar sind. Erfindungsgemäß wird ausgenutzt, daß der Instrumententräger problemlos entlang der Hauptachse 3 durch den Spalt 4 bewegbar ist und jede gewünschte Position einnehmen kann. Dieser Instrumententräger bedarf keiner Abstützung an Hilfseinrichtungen, die außerhalb des Spaltes 4 zu postieren sind und durch die er unvermeidbar Vibrationen u. dgl. unterworfen würde. Der Instrumententräger stützt sich unmittelbar an der Stelle des Stators 1 ab, an der er sich gerade befindet, und ist somit gegen Vibrationen gesichert. Auch ist seine Positionierung besonders einfach. Die die Hauptachse 3 im wesentlichen vollständig umfangende Gestalt des Instrumententrägers verhindert auch, daß dieser sich beim Befahren des Spaltes 4 verkantet und möglicherweise nicht mehr ohne weiteres aus dem Spalt 4 entfernbar ist. Die Gefahr des Verkantens und Verklemmens besteht bei dem dargestellten Instrumententräger prinzipbedingt nicht. In Fig. 1 ist auch dargestellt, wie die maximale Dicke 37 (dargestellt als Doppelpfeil) des Instrumententrägers zu bestimmen ist. Die maximale Dicke 37 ist zu bestimmen entlang bezüglich der Hauptachse 3 radialer Richtungen 36 (beispielhaft dargestellt als Pfeil). Die maximale Dicke 37 ist nicht zu verwechseln mit einem maximalen Durchmesser des Instrumententrägers oder dergleichen. Die maximale Dicke 37 ist zu bestimmen als Maximalwert aus den entlang aller möglichen radialen Richtungen 36 zu messenden Dicken.

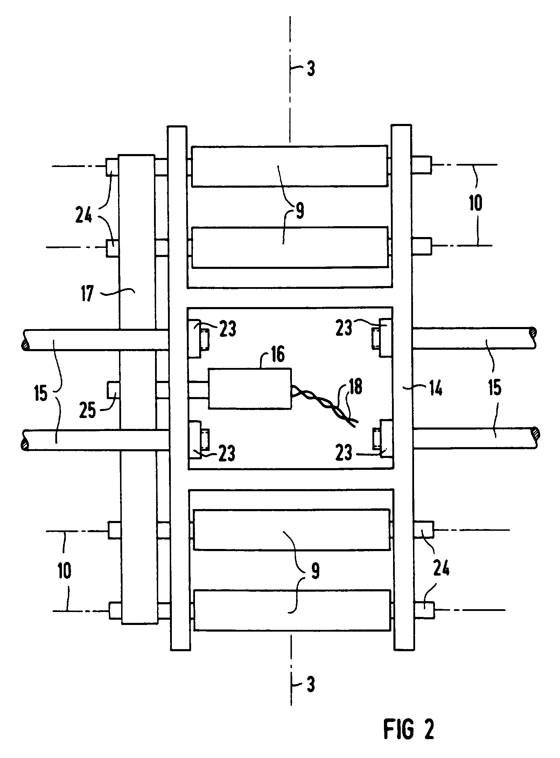

Fig. 2 zeigt einen Ausschnitt aus einem Instrumententräger, gesehen senkrecht zur Hauptachse 3. Der Instrumententräger weist vier Rollen 9 auf, die paarweise dicht zueinander benachbart sind und deren jede um eine Drehachse 10, welche senkrecht zur Hauptachse 3 ausgerichtet ist, drehbar ist. Die Rollen 9 sind drehbar befestigt in einem Rollengestell 14, mit welchem vier Stäbe 15 verbunden sind, welche zu weiteren Rollengestellen 14 reichen und somit zusammen mit diesen das Rahmenteil bilden. Die Stäbe 15 sind in das Rollengestell 14 eingeschraubt und mit Befestigungsmitteln 23, nämlich Muttern, gesichert. Die Rollen 9 sind antreibbar durch einen ersten Motor 16, vorzugsweise einen Elektromotor, der über Anschlußleitungen 18 extern bedienbar ist. Als Kraftübertragungseinrichtung 17 dient ein Antriebsband, welches über eine Abtriebswelle 25 des ersten Motors 16 sowie über entsprechend verlängerte Naben 24 der Rollen 9 gelegt ist. Mithin ist der Instrumententräger mit einem Rahmenteil der in Fig. 2 ausschnittsweise dargestellten Art eine selbstfahrende Einrichtung und bedarf zur Bewegung entlang der Hauptachse 3 keiner Hilfseinrichtung mehr wie z. B. eines Seils oder einer Schiene.

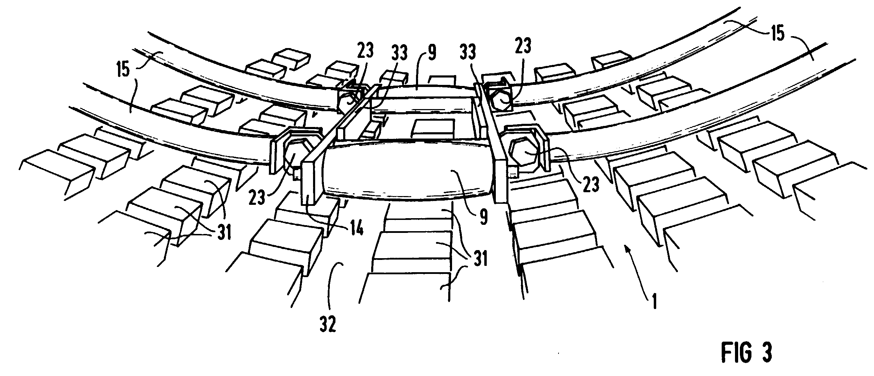

Fig. 3 zeigt eine Ansicht eines Instrumententrägers in der Ausnehmung eines Stators 1. Dargestellt ist ein Rollengestell 14 mit Rollen 9, an das sich gebogene Stäbe 15 anschließen. Diese Stäbe 15 sind mit Befestigungsmitteln 23, und zwar Schrauben, mit dem Rollengestell 14 verbunden. Jede Rolle 9 in dem Rollengestell 14 ist nach Art eines Fasses bauchig ausgewölbt, um zu verhindern, daß eine Kante an der Rolle 9 den Stator 1 beschädigen könnte. Das Rollengestell 14 weist auch zwei Kufen 33 auf, die von dem Stator 1 abgewandt sind. Vermittels solcher Kufen 33 kann der Instrumententräger auf einer aus der Ausnehmung des Stators 1 herausragenden Endkappe eines Rotors 2 (nicht dargestellt) aufsitzen und bei Bedarf um die Hauptachse 3 herum verdreht werden. Auf diese Weise ist die Winkelpositionierung bezüglich der Hauptachse 3 einfach durchführbar, und der Instrumententräger kann auch vor dem Einführen in den Spalt 4 in eine definierte Position gebracht werden.

Einzelheiten des Stators 1 sind ebenfalls aus Fig. 3 ersichtlich: Der Stator 1 ist kein Monolith, sondern besteht aus einer Vielzahl von hintereinander angeordneten und von einander beabstandeten Blechpaketen 31. Diese Blechpakete 31 weisen Nuten auf, welche mit Nutverschlüssen 32 verschlossen sind und die Elemente der elektrischen Wicklung des Stators 1 enthalten. Durch die Anordnung der Blechpakete 31 und Nutverschlüsse 32 ist die von dem Instrumententräger zu befahrende Oberfläche des Stators 1 keineswegs regelmäßig, sondern uneben, was ggf. bei der Auslegung des Instrumententrägers berücksichtigt werden muß. So kann es vorteilhaft sein, nach Art der Darstellung aus Fig. 2 statt einzelner Rollen 9 Paare solcher Rollen 9, welche geeignet voneinander beabstandet sind, zu verwenden.

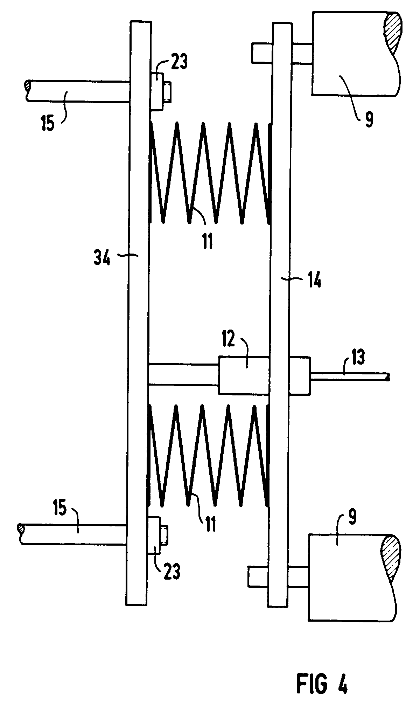

Fig. 4 zeigt einen Ausschnitt aus einer weiteren Ausführungsform des Instrumententrägers. Wiederum ist dieser aufgebaut aus Rollengestellen 14 und Stäben 15 (vgl. Fig. 2). Die Stäbe 15 sind allerdings nicht unmittelbar an dem gezeigten Rollengestell 14 befestigt, sondern an einer neben diesem angeordneten Zusatzleiste 34; wie bereits zu Fig. 2 erwähnt, können die Stäbe 15 in die Zusatzleiste 34 eingeschraubt und mit zusätzlichen Befestigungsmitteln 23, insb. Muttern, gesichert werden. Zwischen Zusatzleiste 34 und Rollengestell 14 eingefügt sind zwei Federelemente 11, nämlich Schraubenfedern, welche dem Instrumententräger eine gewisse Elastizität verleihen und, in radialer Orientierung bezüglich der Hauptachse 3, eine Veränderung seines Umfangs erlauben. Damit ist eine Anpassung an Unebenheiten in dem Stator möglich. Weiterhin befindet sich zwischen der Zusatzleiste 34 und dem Rollengestell 14 eine Dehnvorrichtung 12, nämlich ein pneumatischer Hubkolben, welcher über eine Anschlußleitung 13 extern bedienbar ist und eine Variation des Gleichgewichtsabstandes zwischen der Zusatzleiste 34 und dem Rollengestell 14 gestattet. Somit ist eine gezielte Einstellung des Umfangs des Instrumententrägers möglich, und er kann an Spalte 4 wechselnder Abmessungen angepaßt werden. Darüber hinaus kann der Instrumententräger mittels der Dehnvorrichtung 12 nach Beendigung der Inspektion etwas zusammengezogen werden, um sein Entfernen aus dem Spalt 4 zu erleichtern.

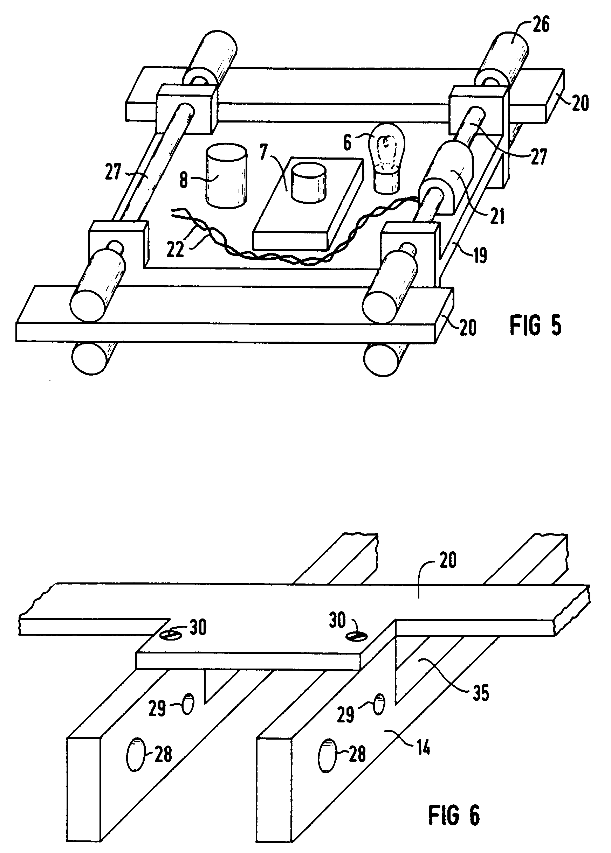

Fig. 5 zeigt eine Instrumentenplattform 19, die entlang zweier Führungsschienen 20 die Hauptachse 3 in einem Spalt 4 umlaufen kann. Die Instrumentenplattform 19 ist gehaltert an zweiten Rollen 26, welche paarweise eine Führungsschiene 20 umgreifen. Zur Verbesserung der Positionsgenauigkeit können die zweiten Rollen 26 und die Führungsschienen 20 gezahnt sein. Angetrieben wird die Instrumentenplattform 19 von einem zweiten Motor 21, welcher über eine zugehörige Anschlußleitung 22 extern bedienbar ist und eine Achse 27 zwischen zwei Rollen 26 antreibt. Die Instrumentenplattform 19 weist beispielhaft eine Lampe 6, eine Kamera 7 und einen Ultraschallprüfkopf 8 auf. Diese drei Mittel 6, 7, 8 stehen stellvertretend für die gesamte Vielzahl von Instrumenten und Hilfseinrichtungen zur Durchführung von Inspektionen. Selbstverständlich sind diese Mittel an Anschlußleitungen und Bedieneinrichtungen angeschlossen, welche der Übersichtlichkeit halber nicht dargestellt sind.

Fig. 6 zeigt eine Teilansicht eines Radgestells 14, an dem eine Führungsschiene 20 zur Führung einer Instrumentenplattform 19 der in Fig. 5 dargestellten Art befestigt ist. Die Führungsschiene 20 ist mittels Schrauben 30 an dem Rollengestell 14 befestigt. Zur Einfügung von Rollen 9 und Stäben 15 hat das Rollengestell entsprechende Bohrungen 28 und 29. Damit eine Instrumentenplattform 19 das Rollengestell 14 passieren kann, weist dieses entsprechende Ausnehmungen 35 auf. In diese Ausnehmungen 35 ragt die Führungsschiene 20 hinein, wobei über und unter der Führungsschiene 20 hinreichend Platz verbleibt, damit die Instrumentenplattform 19 passieren kann.

## Patentansprüche

1. Instrumententräger zur Inspektion einer dynamoelektrischen Maschine, die einen Stator (1) und einen Rotor (2) aufweist, wobei der Rotor (2) bezüglich einer Hauptachse (3) etwa kreiszylindrisch, um die Hauptachse (3) drehbar und unter Belassung eines Spaltes (4) in einer bezüglich der Hauptachse (3) etwa kreiszylindrischen Ausnehmung des Stators (1) angeordnet ist, welcher Instrumententräger Mittel (6, 7, 8) zur Durchführung der Inspektion trägt sowie eine Vielzahl von Rollen (9) aufweist, die, in einer Ebene senkrecht zu einer Achse des Instrumententragers, welche bei der Inspektion mit der Hauptachse (3) zur Deckung gebracht wird, gesehen, gegeneinander versetzt sind und deren jede um eine im wesentlichen senkrecht zu der Achse ausgerichtete zugehörige Drehachse (10) drehbar ist, **gekennzeichnet durch** ein die Achse ringförmig umfangendes Rahmenteil (5), an dem die Mittel (6, 7, 8) zur Durchführung der Inspektion sowie die Rollen (9) befestigt sind.

2. Instrumententräger nach Anspruch 1, dessen Rahmenteil (5) bezüglich der Hauptachse (3) radial elastisch dehnbar ist.

3. Instrumententräger nach Anspruch 2, dessen Rahmenteil (5) zumindest ein Federelement (11) aufweist, welches in bezüglich der Hauptachse (3) tangentialer Richtung elastisch ist.

4. Instrumententräger nach Anspruch 3, dessen Rahmenteil (5) zwei oder drei Federelemente (11) aufweist.

5. Instrumententräger nach einem der Ansprüche 2 bis 4, dessen Rahmenteil (5) zumindest eine Dehnvorrichtung (12) aufweist, durch welche das Rahmenteil (5) radial dehnbar ist und welche über zugehörige Anschlußleitungen (13) extern bedienbar ist.

6. Instrumententräger nach Anspruch 5, bei dem die Dehnvorrichtung (12) eine in bezüglich der Hauptachse (3) etwa tangentialer Richtung wirkende pneumatische Verschiebeeinrichtung (12) ist.

7. Instrumententräger nach einem der vorhergehenden Ansprüche, welcher aufweist:
a) eine Vielzahl von Rollengestellen (14), deren jedes bezüglich der Hauptachse (3) hintereinander angeordnete Rollen (9) trägt;
b) eine Vielzahl von gebogenen Stäben (15), durch die die Rollengestelle (14) untereinander verbunden sind.

8. Instrumententräger nach Anspruch 7, welcher zwischen vier und acht, vorzugsweise sechs, Rollengestelle (14) aufweist.

9. Instrumententräger nach Anspruch 7 oder 8, bei dem jeweils zwei zueinander etwa parallele Stäbe (15) zwei Rollengestelle (14) miteinander verbinden.

10. Instrumententräger nach einem der Ansprüche 7 bis 9, bei dem jeder Stab (12) aus einem elastisch biegsamen Werkstoff besteht.

11. Instrumententräger nach einem der vorhergehenden Ansprüche, bei dem jede Rolle (9) nach Art eines Fasses bauchig ausgewölbt ist.

12. Instrumententräger nach einem der vorhergehenden Ansprüche, bei dem jeweils zwei bezüglich der Hauptachse (3) hintereinander angeordnete Rollen (9) einander dicht benachbart sind.

13. Instrumententräger nach einem der vorhergehenden Ansprüche, der einen ersten Motor (16) mit Kraftübertragungseinrichtungen (17) aufweist, wodurch zumindest eine Rolle (9) antreibbar ist, wobei der erste Motor (16) über eine zugehörige Anschlußleitung (18) extern bedienbar ist.

14. Instrumententräger nach Anspruch 13, bei dem der erste Motor (16) in ein Rollengestell (14) mit mehreren Rollen (9), die bezüglich der Hauptachse (3) hintereinander angeordnet und durch den ersten Motor (16) antreibbar sind, eingebaut ist.

15. Instrumententräger nach einem der vorhergehenden Ansprüche, der eine Instrumentenplattform (19) aufweist, die an dem Rahmenteil (5) gehaltert und entlang des Rahmenteils (5) um die Hauptachse (3) bewegbar ist, und die die Mittel (6, 7, 8) zur Durchführung der Inspektion trägt.

16. Instrumententräger nach Anspruch 15, bei dem das Rahmenteil (5) zumindest eine Führungsschiene (20) aufweist, an der die Instrumentenplattform (19) gehaltert ist.

17. Instrumententräger nach Anspruch 16, bei dem die Instrumentenplattform (20) einen zweiten Motor (21) aufweist, der mit dem Rahmenteil (5), insbesondere mit der Führungsschiene (20), in Kraftschluß steht und durch den die Instrumentenplattform (19) bewegbar ist, wobei der zweite Motor (21) über eine zugehörige Anschlußleitung (22) extern bedienbar ist.

18. Instrumententräger nach einem der vorhergehenden Ansprüche, welcher eine bezüglich der Hauptachse (3) in einer radialen Richtung (36) zu bestimmende maximale Dicke (37) aufweist, welche kleiner als 10 cm, insbesondere kleiner als 5 cm, ist.

19. Verwendung des Instrumententragers nach einem der vorhergehenden Ansprüche zur Inspektion der dynamoelektrischen Ma-schine, wobei der Instrumententräger in den Spalt (4) zwischen dem Stator (1) und dem Rotor (2) eingeführt wird, so daß das Rahmenteil (5) den Rotor (2) umfängt und die Rollen (9) über die Ausnehmung des Stators (1) rollen.

## Claims

1. Instrument carrier for inspecting a dynamoelectric machine which has a stator (1) and a rotor (2), the rotor (2) being arranged in an approximately circularly cylindrical fashion relative to a main axis (3), in a manner rotatable about the main axis (3) and leaving a gap (4) in a recess of the stator which is approximately circularly cylindrical relative to the main axis (3), which instrument carrier carries means (6, 7, 8) for carrying out the inspection and has a multiplicity of rollers (9) which, seen in a plane perpendicular to an axis of the instrument carrier, which axis is brought into coincidence with the main axis (3) during the inspection, are offset with respect to one another, and of which each can rotate about an associated axis (10) of rotation aligned essentially perpendicular to the axis, characterized by a frame part (5) which surrounds the axis in an annular fashion and on which the means (6, 7, 8) for carrying out the inspection and the rollers (9) are mounted.

2. Instrument carrier according to Claim 1, whose frame part (5) can be expanded in a radially elastic fashion relative to the main axis (3).

3. Instrument carrier according to Claim 2, whose frame part (5) has at least one spring element (11) which is elastic in the tangential direction relative to the main axis (3).

4. Instrument carrier according to Claim 3, whose frame part (5) has two or three spring elements (11).

5. Instrument carrier according to one of Claims 2 to 4, whose frame part (5) has at least one expansion device (12) by means of which the frame part (5) can be radially expanded and which can be operated externally via associated connecting leads (13).

6. Instrument carrier according to Claim 5, in which the expansion device (12) is a pneumatic sliding device (12) acting in an approximately tangential direction relative to the main axis (3).

7. Instrument carrier according to one of the preceding claims, which has:
a) a multiplicity of roller frames (14), each of which carries rollers (9) arranged one behind another relative to the main axis (3); and
b) a multiplicity of bent rods (15) by means of which the roller frames (14) are interconnected.

8. Instrument carrier according to Claim 7, which has between four and eight, preferably six, roller frames (14).

9. Instrument carrier according to Claim 7 or 8, in which in each case two rods (15) which are approximately 2parallel to one another connect two roller frames (14) to one another.

10. Instrument carrier according to one of Claims 7 to 9, in which each rod (12) comprises an elastically flexible material.

11. Instrument carrier according to one of the preceding claims, in which each roller (9) is curved outwards belly-like in the manner of a barrel.

12. Instrument carrier according to one of the preceding claims, in which in each case two rollers (9) arranged one behind another relative to the main axis (3) are tightly adjacent to one another.

13. Instrument carrier according to one of the preceding claims, which has a first motor (16) with power-transmitting devices (17), by means of which at least one roller (9) can be driven, the first motor (16) being externally operable via an associated connecting lead (18).

14. Instrument carrier according to Claim 13, in which the first motor (16) is installed in a roller frame (14) having a plurality of rollers (9) which are arranged one behind another relative to the main axis (3) and can be driven by the first motor (16).

15. Instrument carrier according to one of the preceding claims, which has an instrument platform (19) which is held on the frame part (5) and can be moved along the frame part (5) about the main axis (3), and which carries the means (6, 7, 8) for carrying out the inspection.

16. Instrument carrier according to Claim 15, in which the frame part (5) has at least one guide rail (20) on which the instrument platform (19) is held.

17. Instrument carrier according to Claim 16, in which the instrument platform (20) has a second motor (21) , which is force-closed with the frame part (5), in particular with the guide rail (20), and by means of which the instrument platform (19) can be moved, the second motor (21) being externally operable via an associated connecting lead (22).

18. Instrument carrier according to one of the preceding claims, which has a maximum thickness (37) which is to be measured relative to the main axis (3) in a radial direction (36) and is smaller than 10 cm, in particular smaller than 5 cm.

19. Use of the instrument carrier according to one of the preceding claims for inspecting the dynamoelectric machine, the instrument carrier being inserted into the gap (4) between the stator (1) and the rotor (2), so that the frame part (5) surrounds the rotor (2) and the rollers (9) roll over the recess of the stator (1).

## Revendications

1. Support d'instrument pour l'inspection d'une machine dynamo-électrique, qui comporte un stator (1) et un rotor (2), le rotor (2), à peu près cylindrique de section transversale circulaire par rapport à un axe (3) principal, étant monté tournant autour de l'axe principal (3) en laissant subsister un entrefer (4) dans un évidement du stator (1) qui est à peu près cylindrique de section transversale circulaire par rapport à l'axe principal (3), le support d'instrument portant des moyens (6, 7, 8) pour effectuer l'inspection et comportant une pluralité de rouleaux (9), qui sont décalés les uns par rapport aux autres dans un plan perpendiculaire à un axe du support d'instrument qui vient en coïncidence avec l'axe (3) principal lors de l'inspection et dont chacun peut tourner autour d'un axe (10) de rotation associé sensiblement perpendiculaire à l'axe, caractérisé par une partie (5) de cadre, qui entoure annulairement l'axe et à laquelle sont fixés les moyens (6, 7, 8) pour effectuer l'inspection ainsi que les rouleaux (9).

2. Support d'instrument suivant la revendication 1, dont la partie (5) de cadre est extensible élastiquement et radialement par rapport à l'axe principal (3).

3. Support d'instrument suivant la revendication 2, dont la partie (5) de cadre comporte au moins un élément (11) de ressort, qui est élastique dans une direction tangentielle par rapport à l'axe principal (3).

4. Support d'instrument suivant la revendication 3, dont la partie (5) de cadre comporte deux ou trois éléments (11) de ressort.

5. Support d'instrument suivant l'une des revendications 2 à 4, dont la partie (5) de cadre comporte au moins un dispositif (12) d'extension, par lequel la partie (5) de cadre peut être étendue radialement et qui peut être commandée de l'extérieur par l'intermédiaire de lignes (13) de raccordement associées.

6. Support d'instrument suivant la revendication 5, dans lequel le dispositif (12) d'extension est un dispositif (12) de coulissement pneumatique agissant dans une direction à peu près tangentielle par rapport à l'axe principal (3).

7. Support d'instrument suivant l'une des revendications précédentes, qui comporte :
a) une pluralité de châssis (14) de rouleaux, dont chacun porte des rouleaux (9) montés l'un derrière l'autre par rapport à l'axe principal (3) ;
b) une pluralité de barres (15) arquées, par lesquelles les châssis (14) de rouleaux sont reliés entre eux.

8. Support d'instrument suivant la revendication 7, qui comporte un nombre compris entre quatre et huit, de préférence six, châssis (14) de rouleaux.

9. Support d'instrument suivant la revendication 7 ou 8, dans lequel deux barres (15) à peu près parallèles l'une à l'autre relient l'un à l'autre deux châssis (14) de rouleaux.

10. Support d'instrument suivant l'une des revendications 7 à 9, dans lequel chaque barre (12) est en un matériau flexible élastiquement.

11. Support d'instrument suivant l'une des revendications précédentes, dans lequel chaque rouleau (9) est bombé en forme de ventre à la manière d'un tonneau.

12. Support d'instrument suivant l'une des revendications précédentes, dans lequel deux rouleaux (9) montés l'un derrière l'autre par rapport à l'axe principal (3) sont à proximité immédiate l'un de l'autre.

13. Support d'instrument suivant l'une des revendications précédentes, qui comporte un premier moteur (16) à dispositifs (17) de transmission de force, par lesquels au moins un rouleau (9) peut être entraîné, le premier moteur (16) pouvant être commandé de l'extérieur par l'intermédiaire d'une ligne (18) de raccordement associée.

14. Support d'instrument suivant la revendication 13, dans lequel le premier moteur (16) est inséré dans un châssis (14) à plusieurs rouleaux (9), qui sont montés l'un derrière l'autre par rapport à l'axe (3) principal et qui peuvent être entraînés par le premier moteur (16).

15. Support d'instrument suivant l'une des revendications précédentes, qui comporte une plate-forme (19) d'instruments, qui est maintenue à la partie (5) de cadre, qui peut être déplacée le long de la partie (5) de cadre autour de l'axe (3) principal et qui porte les moyens (6, 7, 8) pour effectuer l'inspection.

16. Support d'instrument suivant la revendication 15, dans lequel la partie (5) de cadre comporte au moins un rail (20) de guidage, auquel la plate-forme (19) d'instruments est maintenue.

17. Support d'instrument suivant la revendication 16, dans lequel la plate-forme (20) d'instruments comporte un second moteur (21), qui est en liaison positive avec la partie (5) de cadre, notamment avec le rail (20) de guidage et par lequel la plate-forme (19) d'instruments peut être déplacée, le second moteur (21) pouvant être commandé de l'extérieur par l'intermédiaire d'une ligne (22) de raccordement associée.

18. Support d'instrument suivant l'une des revendications précédentes, ayant une épaisseur maximum à déterminer dans une direction (36) radiale par rapport à l'axe principal (3), qui est plus petite que 10 cm et notamment plus petite que 5 cm.

19. Utilisation du support d'instrument suivant l'une des revendications précédentes pour l'inspection de la machine dynamo-électrique, le support d'instrument étant introduit dans l'entrefer (4) entre le stator (1) et le rotor (2), de sorte que la partie (5) de cadre entoure le rotor (2) et que les rouleaux (9) roulent sur l'évidement du stator (1).
